# EUROPEAN PATENT APPLICATION

(11) **EP 4 600 959 A1**
(43) Date of publication of application: **13.08.2025**
(21) Application number: 24861341.6
(22) Date of filing: 29.08.2024
(51) Int. Cl.: G11C 11/4094

(54) **MEMORY**

(30) Priority: 27.12.2023 CN 202311841372; 16.08.2024 CN 202411133400
(71) Applicant: CXMT Corporation, Hefei, Anhui 230601 (CN)
(72) Inventor: SHANG, Weibing, Hefei, Anhui 230601 (CN)
(74) Representative: Gulde & Partner
(86) International application number: PCT/CN2024/115490
(87) International publication number: WO 2025/138974

(57) **Abstract**

The present disclosure provides a memory, including multiple layers of memory chips and a logic chip stacked in a third direction. Each of the memory chips includes multiple storage structures arranged in a first direction and a second direction. The i^{th} bit line in a first storage structure is connected to the i^{th} bit line in a fourth storage structure. The i^{th} bit line in a third storage structure is connected to the i^{th} bit line in a second storage structure. The first storage structure is adjacent to the third storage structure in the third direction. The fourth storage structure and the third storage structure are located in the same one of the memory chips and adjacent to each other in the first direction. The second storage structure is adjacent to the fourth storage structure in the third direction. The second storage structure and the first storage structure are located in the same one of the memory chips and adjacent to each other in the first direction.

## Description

### CROSS-REFERENCE TO RELATED APPLICATIONS

This application is based upon and claims priority to Chinese Patent Application No. 202311841372.2, filed with the China National Intellectual Property Administration on December 27, 2023 and entitled "MEMORY", and claims priority to Chinese Patent Application No. 202411133400.X, filed with the China National Intellectual Property Administration on August 16, 2024 and entitled "MEMORY".

### TECHNICAL FIELD

The present disclosure relates to the field of semiconductor technologies, and in particular, to a memory.

### BACKGROUND

A dynamic random access memory (DRAM) completes data write operations to the memory by storing charge in capacitors of storage cells, and completes data read operations from the memory by reading charge in capacitors of storage cells. In the DRAM, multiple sense amplifiers are respectively connected to bit lines BL and reference bit lines BLB. In a process of performing a data read operation, a sense amplifier is configured to amplify a voltage difference between a bit line BL and a reference bit line BLB. However, relatively large parasitic capacitance exists between bit lines, adversely affecting memory performance.

### SUMMARY

An embodiment of the present disclosure provides a memory, including multiple layers of memory chips and a logic chip stacked in a third direction, each of the memory chips including multiple storage structures arranged in a first direction and a second direction, each of the storage structures having multiple bit lines arranged in the second direction, the logic chip including multiple sense amplifiers arranged in the second direction, and every two of the first direction, the second direction, and the third direction intersecting each other;
the i^{th} bit line in a first storage structure being connected to the i^{th} bit line in a fourth storage structure, and being connected to one end of a corresponding one of the sense amplifiers; and
the i^{th} bit line in a third storage structure being connected to the i^{th} bit line in a second storage structure, and being connected to the other end of the corresponding one of the sense amplifiers; and i being an odd number or an even number;
the first storage structure being adjacent to the third storage structure in the third direction; the fourth storage structure and the third storage structure being located in the same one of the memory chips and adjacent to each other in the first direction; the second storage structure being adjacent to the fourth storage structure in the third direction; and the second storage structure and the first storage structure being located in the same one of the memory chips and adjacent to each other in the first direction.

In some embodiments, when i is an even number, the (i+1)^{th} bit line in the first storage structure is connected to the (i+1)^{th} bit line in the third storage structure, and the (i+1)^{th} bit line in the second storage structure is connected to the (i+1)^{th} bit line in the fourth storage structure; and
when i is an odd number, the (i-1)^{th} bit line in the first storage structure is connected to the (i-1)^{th} bit line in the third storage structure, and the (i-1)^{th} bit line in the second storage structure is connected to the (i-1)^{th} bit line in the fourth storage structure.

In some embodiments, the memory further comprises a fifth storage structure and a sixth storage structure;
the i^{th} bit line in the third storage structure is further connected to the k^{th} bit line in the fifth storage structure; and
the i^{th} bit line in the fourth storage structure is further connected to the k^{th} bit line in the sixth storage structure;
the fifth storage structure and the sixth storage structure being located in the same one of the memory chips and adjacent to each other in the first direction, the fifth storage structure being adjacent to the third storage structure in the third direction, the sixth storage structure being adjacent to the fourth storage structure in the third direction, and k is an odd number or an even number.

In some embodiments, the memory further includes a seventh storage structure and an eighth storage structure;
the k^{th} bit line in the fifth storage structure is further connected to the k^{th} bit line in the eighth storage structure; and
the k^{th} bit line in the sixth storage structure is further connected to the k^{th} bit line in the seventh storage structure;
the seventh storage structure and the eighth storage structure being located in the same one of the memory chips and adjacent to each other in the first direction, the seventh storage structure being adjacent to the fifth storage structure in the third direction, and the eighth storage structure being adjacent to the sixth storage structure in the third direction.

In some embodiments, both i and k are even numbers, or both i and k are odd numbers, or i is one of an odd number or an even number, and k is the other of the odd number or the even number.

In some embodiments, the memory further includes a ninth storage structure and a tenth storage structure; and in the first direction, the ninth storage structure is located on a side of the fourth storage structure away from the third storage structure, and the tenth storage structure is located on a side of the sixth storage structure away from the fifth storage structure;
the m^{th} bit line of the fourth storage structure is connected to the m^{th} bit line of the tenth storage structure; and
the m^{th} bit line of the sixth storage structure is connected to the m^{th} bit line of the ninth storage structure;
i being one of an odd number or an even number, and m being the other of the odd number or the even number.

In some embodiments, the memory further includes an eleventh storage structure and a twelfth storage structure; and in the first direction, the eleventh storage structure is located on a side of the second storage structure away from the first storage structure, and the twelfth storage structure is located on a side of the eighth storage structure away from the seventh storage structure;
the m^{th} bit line of the second storage structure is connected to the m^{th} bit line of the fourth storage structure; and
the m^{th} bit line of the sixth storage structure is connected to the m^{th} bit line of the eighth storage structure.

In some embodiments, a bit line connection manner between the first storage structure, the second storage structure, the third storage structure, the fourth storage structure, the fifth storage structure, the sixth storage structure, the seventh storage structure, and the eighth storage structure is denoted as a first twisted manner; and a bit line connection manner between the second storage structure, the fourth storage structure, the sixth storage structure, the eighth storage structure, the ninth storage structure, the tenth storage structure, the eleventh storage structure, and the twelfth storage structure is denoted as a second twisted manner; and
in the first direction, twisted manners between adjacent ones of the storage structures are alternately the first twisted manner and the second twisted manner.

In some embodiments, the memory is a dynamic random access memory, and the logic chip is located in a first wafer; and
the multiple layers of memory chips are all located in a second wafer, and the multiple layers of memory chips are connected through a through-silicon via; or the multiple layers of memory chips are respectively located in different wafers, and the multiple layers of memory chips are connected in a hybrid bonding manner.

An embodiment of present disclosure provides a memory, including multiple layers of memory chips and a logic chip stacked in a third direction. Each of the memory chips includes multiple storage structures arranged in a first direction and a second direction. Each of the storage structures has multiple bit lines arranged in the second direction. The logic chip includes multiple sense amplifiers arranged in the second direction. Every two of the first direction, the second direction, and the third direction intersect each other. The i^{th} bit line in a first storage structure is connected to the i^{th} bit line in a fourth storage structure, and is connected to one end of a corresponding one of the sense amplifiers. The i^{th} bit line in a third storage structure is connected to the i^{th} bit line in a second storage structure, and is connected to the other end of the corresponding one of the sense amplifiers. i is an odd number or an even number. The first storage structure is adjacent to the third storage structure in the third direction. The fourth storage structure and the third storage structure are located in the same one of the memory chips and adjacent to each other in the first direction. The second storage structure is adjacent to the fourth storage structure in the third direction. The second storage structure and the first storage structure are located in the same one of the memory chips and adjacent to each other in the first direction. Based on this connection manner, parasitic capacitance between bit lines can be reduced, and system noise can be decreased, so that a bit line in a storage structure adjacent to a certain storage structure can eliminate adverse impact between the bit lines in the storage structures, and accuracy of data transmitted by the bit lines can be ensured. In addition, as the adverse impact is eliminated, the bit lines may be further made closer to reduce a distance between the bit lines, thereby facilitating a high degree of integration of the memory and increasing storage density.

### BRIEF DESCRIPTION OF DRAWINGS

FIG. 1 is a schematic structural diagram of a DRAM according to an embodiment of the present disclosure;
FIG. 2 is schematic structural diagram 1 of composition of a memory according to an embodiment of the present disclosure;
FIG. 3 is schematic structural diagram 2 of composition of a memory according to an embodiment of the present disclosure;
FIG. 4 is schematic structural diagram 3 of composition of a memory according to an embodiment of the present disclosure;
FIG. 5 is schematic structural diagram 4 of composition of a memory according to an embodiment of the present disclosure; and
FIG. 6 is schematic structural diagram 5 of composition of a memory according to an embodiment of the present disclosure.

### DESCRIPTION OF EMBODIMENTS

The technical solutions in the embodiments of the present disclosure are clearly described below with reference to the accompanying drawings in the embodiments of the present disclosure. It may be understood that specific embodiments described herein are merely intended to explain related disclosure, but are not intended to limit the present disclosure. In addition, it should be further noted that for ease of description, only a part related to the related disclosure is shown in the accompanying drawings.

Unless otherwise defined, all technical and scientific terms employed in this specification have the same meanings as those commonly understood by a person skilled in the technical field of the present disclosure. The terms utilized in this specification are merely intended to describe the embodiments of the present disclosure, but are not intended to limit the present disclosure.

The following descriptions relate to "some embodiments" describing a subset of all possible embodiments. However, it may be understood that "some embodiments" may be the same subset or different subsets of all the possible embodiments, and may be combined with each other when there is no conflict.

It should be noted that the term "first/second/third/.../twelfth" in the embodiments of the present disclosure is merely intended to distinguish between similar objects, and does not represent specific sorting for the objects. It may be understood that "first/second/third/.../twelfth" may be interchanged for a specific sequence or order if allowed, so that the embodiments of the present disclosure described herein can be implemented in a sequence other than those shown or described herein.

Before the embodiments of the present disclosure are further described in detail, nouns and terms in the embodiments of the present disclosure are first described. The nouns and the terms in the embodiments of the present disclosure are applicable to the following explanations:
dynamic random access memory (DRAM);
sense amplifier/sense amplifier (SA);
hybrid bonding (HB);
contact pad (PAD);
sense margin (Sense Margin);
bit line (BL); and
storage structure (CELL MAT).

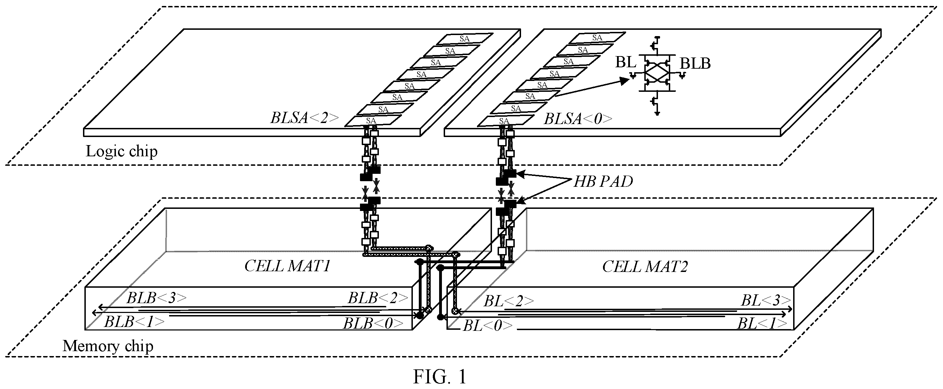

FIG. 1 is a schematic structural diagram of a DRAM according to an embodiment of the present disclosure. As shown in FIG. 1, the DRAM includes a logic chip and memory chips. Each of the memory chips includes multiple storage structures (denoted as CELL MAT). Each of the storage structures includes multiple storage cells (not shown in the figure) configured to store data and multiple bit lines. One or more storage cells are connected to one bit line. The logic chip includes multiple sense amplifiers SA. Each sense amplifier SA is connected to a bit line BL and a reference bit line BLB. The bit line BL and the reference bit line BLB are originated from different storage structures.

Two storage structures are shown in FIG. 1. The two storage structures are respectively a storage structure CELL MAT 1 and a storage structure CELL MAT2. Four bit lines BL are shown in each storage structure. As shown in FIG. 1, an even-numbered bit line in the storage structure CELL MAT1 and an even-numbered bit line in the storage structure CELL MAT2 serve as references to each other, and are connected to the same sense amplifier SA. Herein, a bit line serving as a reference is denoted as a reference bit line BLB. It should be understood that, in different data read processes, a bit line and a reference bit line may be interchanged. FIG. 1 is merely an example.

As shown in FIG. 1, the first even-numbered bit line BL<0> in the storage structure CELL MAT2 and the first even-numbered reference bit line BLB<0> in the storage structure CELL MAT1 are both connected to a sense amplifier BLSA<0>. The second even-numbered bit line BL<2> in the storage structure CELL MAT2 and the second even-numbered reference bit line BLB<2> in the storage structure CELL MAT1 are both connected to a sense amplifier BLSA<2>. An odd-numbered bit line BL<1> and an odd-numbered bit line BL<3> in the storage structure CELL MAT2 and bit lines in another storage structure serve as mutual references to each other. An odd-numbered reference bit line BLB<1> and an odd-numbered reference bit line BLB<3> in the storage structure CELL MAT1 and bit lines in another storage structure serve as mutual references to each other.

In the memory shown in FIG. 1, very large noise exists between bit lines, affecting a sense margin and thus adversely affecting increase in storage density. Overall bit-line parasitic capacitance includes parasitic capacitance between bit lines and parasitic capacitance of the other conductive substances in the bit lines and the memory. Especially in a 4F2 structure, as a proportion of the parasitic capacitance between bit lines to the overall bit-line parasitic capacitance increases, the problem becomes more serious, limiting a degree of integration of the memory.

Based on this, an embodiment of the present disclosure provides a memory. Bit lines in the memory are connected in a twisted connection manner. Based on this twisted connection manner, parasitic capacitance between bit lines can be reduced, system noise can be decreased, and a sense margin can be increased, so that a bit line in a storage structure adjacent to a certain storage structure can eliminate adverse impact between the bit lines in the storage structures, and accuracy of data transmitted by the bit lines can be ensured. In addition, as the adverse impact is eliminated, the bit lines isfurther made closer to reduce a distance between the bit lines, thereby facilitating a high degree of integration of the memory and increasing storage density.

The embodiments of the present disclosure are described below in detail with reference to the accompanying drawings.

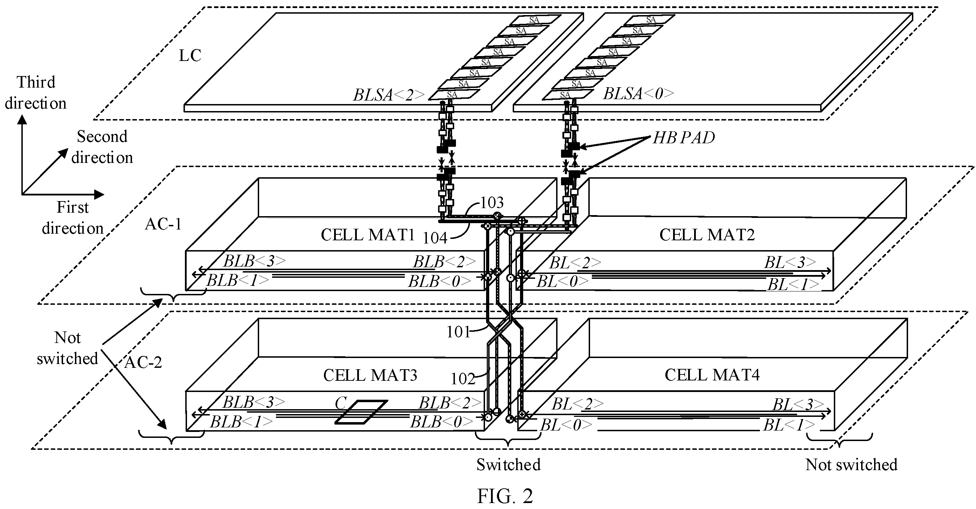

In an embodiment of the present disclosure, FIG. 2 is schematic structural diagram 1 of composition of a memory according to this embodiment of the present disclosure. As shown in FIG. 2, the memory includes multiple layers of memory chips AC and a logic chip LC stacked in a third direction. Each layer of memory chip AC includes multiple storage structures CELL MAT arranged in a first direction and a second direction. Each storage structure CELL MAT has multiple bit lines BL arranged in the second direction. Each logic chip LC includes multiple sense amplifiers SA arranged in the second direction. Every two of the first direction, the second direction, and the third direction intersect each other. In some others embodiments, the multiple storage structures in each layer of memory chip AC are arranged only in the first direction or the second direction. That is, each layer of memory chip may include multiple storage structures arranged in a linear manner or include multiple storage structures arranged in an array.

The i^{th} bit line BLB<i> in a first storage structure CELL MAT1 is connected to the i^{th} bit line BL<i> in a fourth storage structure CELL MAT4, and is connected to one end of a corresponding sense amplifier BLSA to serve as one of a bit line or a reference bit line.

The i^{th} bit line BLB<i> in a third storage structure CELL MAT3 is connected to the i^{th} bit line BL<i> in a second storage structure CELL MAT2, and is connected to the other end of the corresponding sense amplifier BLSA to serve as the other of the bit line or the reference bit line. i is an odd number or an even number.

The first storage structure CELL MAT1 is adjacent to the third storage structure CELL MAT3 in the third direction. The fourth storage structure CELL MAT4 and the third storage structure CELL MAT3 are located in the same memory chip AC-2 and adjacent to each other in the first direction. The second storage structure CELL MAT2 is adjacent to the fourth storage structure CELL MAT4 in the third direction. The second storage structure CELL MAT2 and the first storage structure CELL MAT1 are located in the same memory chip AC-1 and adjacent to each other in the first direction.

It should be noted that, this embodiment of the present disclosure relates to semiconductor technologies, for example, relates to a DRAM circuit, and is applied to various memories. In this embodiment of the present disclosure, multi-layer stacking and twisted bit lines are utilized to cancel noise.

As shown in FIG. 2, an extension direction of the bit lines BL is denoted as the first direction, an arrangement direction of the bit lines BL is denoted as the second direction, and a stacking direction of the memory chips AC and the logic chip LC is denoted as the third direction. In this embodiment, as an example, every two of the first direction, the second direction, and the third direction are perpendicular to each other. For ease of description, the first direction is regarded as a left-right direction, the second direction is regarded as a front-back direction, and the third direction is regarded as an up-down direction.

It should be further noted that, at least some of bit lines in two storage structures CELL MAT adjacent to each other in the first direction serve as mutual references to each other. The bit lines in the two adjacent storage structures CELL MAT are respectively denoted as a bit line BL and a reference bit line BLB. It may be understood that, in different cases, a bit line BL and a reference bit line BLB may be interchanged. In this embodiment, the reference bit line BLB may also be directly referred to as a bit line BL.

In this embodiment, each storage structure includes multiple storage cells. One bit line is connected to multiple storage cells, and is connected to a corresponding sense amplifier. As an example, a storage structure has N bit lines, and the bit lines are numbered starting from 0 in the storage structure. i is an odd number or an even number greater than or equal to 0 and less than N.

In this embodiment of the present disclosure, specific implementations are mainly described by an example with i being an even number. A case with i being an odd number is the same as that with i being an even number, and therefore the same description is omitted.

As shown in FIG. 2, the bit line BLB<i> in the first storage structure CELL MAT1 and the bit line BL<i> in the second storage structure CELL MAT2 serve as mutual references to each other, and both bit lines are connected to the same sense amplifier SA. The bit line BLB<i> in the third storage structure CELL MAT3 and the bit line BL<i> in the fourth storage structure CELL MAT4 serve as mutual references to each other, and both bit lines are connected to the same sense amplifier SA. i is an odd number or an even number. That is, two odd-numbered bit lines or even-numbered bit lines ranked at the same place in adjacent storage structures serve as mutual references to each other.

FIG. 2 shows two layers of memory chips AC, respectively denoted as a first memory chip AC-1 and a second memory chip AC-2. The first memory chip AC-1 includes a first storage structure CELLMAT1 and a second storage structure CELL MAT2. The second memory chip AC-2 includes a third storage structure CELL MAT3 and a fourth storage structure CELL MAT4. In the accompanying drawings of the embodiments of the present disclosure, four bit lines in each storage structure are shown merely as examples. In practice, each storage structure may include more bit lines. Similarly, each memory chip may include more storage structures, and the memory may include more layers of memory chips. The first storage structure CELL MAT1 is located directly above the third storage structure CELL MAT3. The second storage structure CELL MAT2 is located directly above the fourth storage structure CELL MAT4. The fourth storage structure CELL MAT4 is located to the lower right of the first storage structure CELL MAT1. The third storage structure CELL MAT3 is located to the lower left of the second storage structure CELL MAT2.

A connection line from a bit line in each storage structure to a sense amplifier is referred to as a bit-line connection line. As shown in FIG. 2, a bit line BLB<0> in the first storage structure CELL MAT 1 is connected to a bit line BL<0> in the fourth storage structure CELL MAT4 through a first bit-line connection line 101, and is connected to one end of a sense amplifier BLSA<0>. A bit line BL<0> in the second storage structure CELL MAT2 is connected to a bit line BLB<0> in the third storage structure CELL MAT3 through a second bit-line connection line 102, and is connected to the other end of the sense amplifier BLSA<0>. A bit line BLB<2> in the first storage structure CELL MAT 1 is connected to a bit line BL<2> in the fourth storage structure CELL MAT4 through a third bit-line connection line 103, and is connected to one end of a sense amplifier BLSA<2>. A bit line BL<2> in the second storage structure CELL MAT2 is connected to a bit line BLB<2> in the third storage structure CELL MAT3 through a fourth bit-line connection line 104, and is connected to the other end of the sense amplifier BLSA<2>. C in the third storage structure CELL MAT3 represents a capacitor between bit lines in the same storage structure.

In this way, as shown in FIG. 2, an even-numbered bit line in a storage structure is not directly connected to a bit line at a corresponding position in a storage structure adjacent to this storage structure in the third direction, but is connected to a diagonal storage structure in a "twisted" manner. A storage structure adjacent to the current storage structure in the third direction is denoted as a vertically-adjacent structure. The diagonal storage structure and the vertically-adjacent structure are adjacent to each other in the first direction, and at least some of the bit lines serve as mutual references to each other. Based on such a twisted connection manner, parasitic capacitance between bit lines can be reduced, and coupling noise between memory chips can be decreased, thereby ensuring that a nearby bit line does not affect data transmitted by the bit lines and cause a data transmission error.

For example, data reading is performed on the second storage structure CELL MAT2. It is assumed that data transmitted by the bit line BL<0>, a bit line BL<1>, and the bit line BL<2> in the second storage structure CELL MAT2 are respectively 1 (a logic high level), 0 (a logic low level), and 1. In this case, data on the bit line BLB<0>, a bit line BLB<1>, and the bit line BLB<2> in the first storage structure CELL MAT1 may be relatively regarded as 0, 1, and 0. Data amplification of the bit line BL<0> and the bit line BL<2> in the second storage structure CELL MAT2 adversely affects the bit line BL<1>. For example, a potential of the bit line BL<1> may be pulled up due to the coupling effect of parasitic capacitance, and consequently, the data on the bit line BL<1> may be misread or miswritten as 1. In this case, based on such a "twisted" structure, the bit line BL<0> in the fourth storage structure CELL MAT4 is connected to the bit line BLB<0> in the first storage structure CELL MAT1, and therefore also exhibits 0. Similarly, the data on the bit line BL<2> in the fourth storage structure CELL MAT4 may also be regarded as 0. The bit line BL<0> and the bit line BL<2> in the fourth storage structure CELL MAT4 also cause impact on the bit line BL<1> in the second storage structure CELL MAT2. In addition, as the data on the bit line BL<0> and the bit line BL<2> in the fourth storage structure CELL MAT4 is 0, this impact is reversed to impact caused by the bit line BL<0> and the bit line BL<2> in the second storage structure CELL MAT2 on the bit line BL<1>. This helps cancel at least some of the impact caused by the bit line BL<0> and the bit line BL<2> in the second storage structure CELL MAT2, and ensures that data reading and writing through the bit line BL<1> in the second storage structure CELL MAT2 are correct. The same principle applies to reading through the other bit lines, and details are omitted herein for simplicity.

In some embodiments, two storage structures adjacent to each other in the third direction are staggered by one bit line pitch in the second direction.

In this way, in this embodiment of the present disclosure, the usage of the twisted interconnection of data lines is conducive to canceling noise (coupling noise between different bit lines in the same storage structure and bit line coupling noise between adjacent storage structures in the third direction), thereby increasing a sense margin and facilitating implementation of a higher degree of integration of a DRAM.

It should be noted that, to clearly show the structure of the memory, the accompanying drawings are not drawn to scale. In practice, the memory chips are not very far from each other in the third direction as in the figure. Therefore, the bit lines in the storage structures adjacent to each other the third direction may affect each other.

It should be further noted that, for the example of FIG. 2, an even-numbered bit line in a storage structure is twisted to compensate for coupling noise. In other words, the bit line is connected to a bit line directly below it in an original case, but now is connected to a bit line directly below one serving as mutual references with this even-numbered bit line instead. A connection object is "switched". In addition, if an even-numbered bit line in a storage structure is twisted and connected to a bit line in a memory chip on one side of the third direction, an odd-numbered bit line in the storage structure may be arranged to be connected to a bit line in a memory chip on the same side without being twisted. That is, a connection object is "not switched".

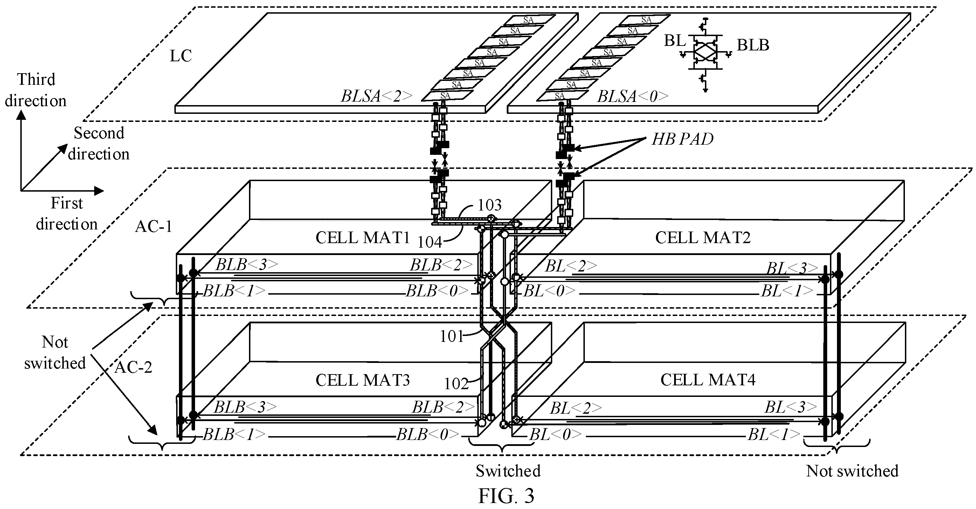

Based on FIG. 2, as shown in FIG. 3, in some embodiments, when i is an even number, the (i+1)^{th} bit line BLB<i+1> in the first storage structure CELL MAT1 is connected to the (i+1)^{th} bit line BLB<i+1> in the third storage structure CELL MAT3; and the (i+1)^{th} bit line BL<i+1> in the second storage structure CELL MAT2 is connected to the (i+1)^{th} bit line BL<i+1> in the fourth storage structure CELL MAT4.

As shown in FIG. 3, in this example, the bit line BLB<1> in the first storage structure CELL MAT1 is connected to a bit line BLB<1> in the third storage structure CELL MAT3, and is connected to a corresponding sense amplifier (not shown in the figure); a bit line BLB<3> in the first storage structure CELL MAT1 is connected to a bit line BLB<3> in the third storage structure CELL MAT3, and is connected to a corresponding sense amplifier (not shown in the figure); a bit line BL<1> in the second storage structure CELL MAT2 is connected to a bit line BL<1> in the fourth storage structure CELL MAT4, and is connected to a corresponding sense amplifier (not shown in the figure); and a bit line BL<3> in the second storage structure CELL MAT2 is connected to a bit line BL<3> in the fourth storage structure CELL MAT4, and is connected to a corresponding sense amplifier (not shown in the figure).

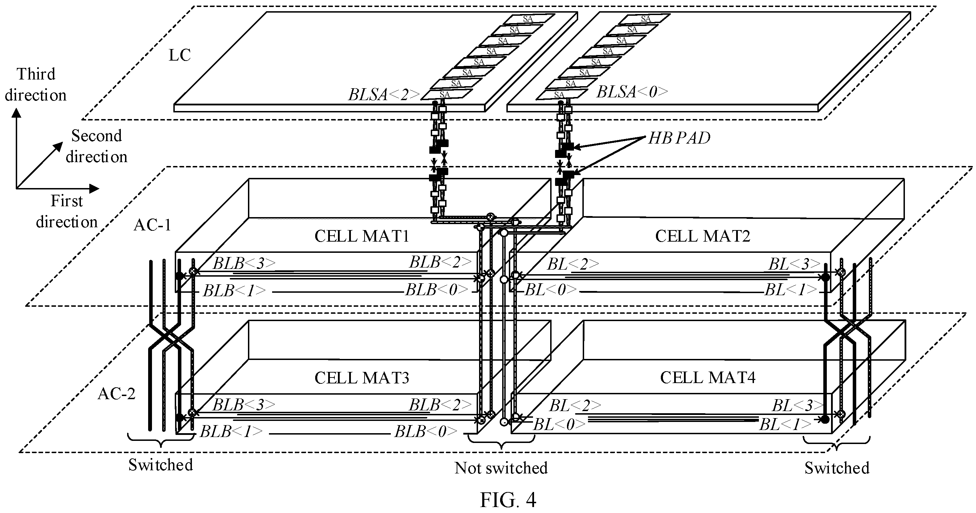

As shown in FIG. 4, in some other embodiments, when i is an odd number, the (i-1)^{th} bit line BLB<i-1> in the first storage structure CELL MAT1 is connected to the (i-1)^{th} bit line BLB<i-1> in the third storage structure CELL MAT3, and the (i-1)^{th} bit line BL<i-1> in the second storage structure CELL MAT2 is connected to the (i-1)^{th} bit line BL<i-1> in the fourth storage structure CELL MAT4.

As shown in FIG. 4, in this example: The first bit line BLB<1> in the first storage structure CELL MAT 1 is twisted and connected to a sequentially corresponding bit line in a storage structure (not shown in the figure) located on the lower left of the first storage structure CELL MAT1, and is connected to a corresponding sense amplifier (not shown in the figure). The first bit line BLB<1> has the same twisted manner as an even-numbered bit line in FIG. 3. The same principle applies to the third bit line BLB<3> in the first storage structure CELL MAT1. The first bit line BLB<1> in the third storage structure CELL MAT3 is twisted and connected to a sequentially corresponding bit line in a storage structure (not shown in the figure) located on the upper left of the third storage structure CELL MAT3, and is connected to a corresponding sense amplifier (not shown in the figure). The same principle applies to the third bit line BLB<3> in the third storage structure CELL MAT3. The first bit line BL<1> in the second storage structure CELL MAT2 is twisted and connected to a sequentially corresponding bit line in a storage structure (not shown in the figure) located on the lower right of the second storage structure CELL MAT2, and is connected to a corresponding sense amplifier (not shown in the figure). The same principle applies to the third bit line BL<3> in the second storage structure CELL MAT2. The first bit line BL<1> in the fourth storage structure CELL MAT4 is twisted and connected to a sequentially corresponding bit line in a storage structure (not shown in the figure) located on the upper right of the fourth storage structure CELL MAT2, and is connected to a corresponding sense amplifier (not shown in the figure). The same principle applies to the third bit line BL<3> in the fourth storage structure CELL MAT4. An even-numbered bit line BLB<0> in the first storage structure CELL MAT1 is directly connected to an even-numbered bit line BLB<0> in the third storage structure CELL MAT3 below the first storage structure CELL MAT1. The same principle applies to an even-numbered bit line BLB<2> in the first storage structure CELL MAT1. An even-numbered bit line BL<0> in the second storage structure CELL MAT2 is directly connected to an even-numbered bit line BL<2> in the fourth storage structure CELL MAT4 below the second storage structure CELL MAT2. The same principle applies to an even-numbered bit line BL<2> in the second storage structure CELL MAT2.

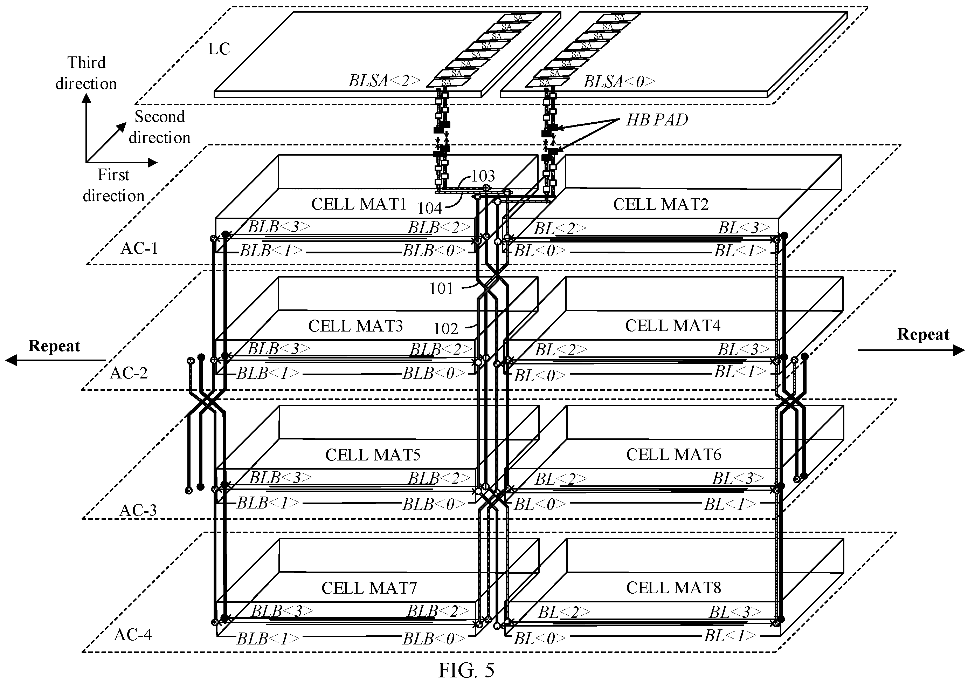

Based on FIG. 2, as shown in FIG. 5, the memory further includes a fifth storage structure CELL MATS and a sixth storage structure CELL MAT6.

The i^{th} bit line BLB<i> in the third storage structure CELL MAT3 is further connected to the k^{th} bit line BLB<k> in the fifth storage structure CELL MATS.

The i^{th} bit line BL<i> in the fourth storage structure CELL MAT4 is further connected to the k^{th} bit line BL<k> in the sixth storage structure CELL MAT6.

The fifth storage structure CELL MATS and the sixth storage structure CELL MAT6 are located in the same memory chip AC-3 and adjacent to each other in the first direction, the fifth storage structure CELL MATS is adjacent to the third storage structure CELL MAT3 in the third direction, the sixth storage structure CELL MAT6 is adjacent to the fourth storage structure CELL MAT4 in the third direction, and k is an odd number or an even number.

Both i and k are even numbers, or both i and k are odd numbers, or i is one of an odd number or an even number, and k is the other of the odd number or the even number.

It should be noted that, i may be equal to k when both i and k are odd numbers or even numbers, and a difference between i and k may be 1 when one of i and k is an odd number and the other is an even number. In FIG. 5, as an example, both i and k are even numbers, and i is equal to k. Implementation principles of the other cases are similar, and details are not described with drawings in this embodiment.

As shown in FIG. 5, the memory further includes the third memory chip AC-3, and the third memory chip AC-3 includes the fifth storage structure CELL MATS and the sixth storage structure CELL MAT6. The fifth storage structure CELL MATS is located below the third storage structure CELL MAT3, and the sixth storage structure CELL MAT6 is located below the fourth storage structure CELL MAT4.

In this example, an even-numbered bit line in the second memory chip AC-2 is twisted and connected to an even-numbered bit line in the first memory chip AC-1 located above, and is not "twisted" in connection to an even-numbered bit line in the third memory chip AC-3 located below. In other words, one bit line of any memory chip can only be twisted and connected to one bit line of a memory chip located on one side of the third direction, and cannot be twisted and connected to one bit line of each of two memory chips located on both sides of the third direction. As shown in FIG. 5, a bit line BLB<0> in the third storage structure CELL MAT3 is connected to a bit line BLB<0> in the fifth storage structure CELL MATS; a bit line BLB<2> in the third storage structure CELL MAT3 is connected to a bit line BLB<2> in the fifth storage structure CELL MATS; a bit line BL<0> in the fourth storage structure CELL MAT4 is connected to a bit line BL<0> in the sixth storage structure CELL MAT6; and a bit line BL<2> in the fourth storage structure CELL MAT4 is connected to a bit line BL<2> in the sixth storage structure CELL MAT6.

It can be learned that, for connection in the third direction, the i^{th} bit line may be "twisted" on one side and "not twisted" on the other side.

Further, as shown in FIG. 5, in some embodiments, the memory further includes a seventh storage structure CELL MAT7 and an eighth storage structure CELL MAT8.

The k^{th} bit line BLB<k> in the fifth storage structure CELL MATS is further connected to the k^{th} bit line BL<k> in the eighth storage structure CELL MAT8.

The k^{th} bit line BL<k> in the sixth storage structure CELL MAT6 is further connected to the k^{th} bit line BLB<k> in the seventh storage structure CELL MAT7.

The seventh storage structure CELL MAT7 and the eighth storage structure CELL MAT8 are located in the same memory chip and adjacent to each other in the first direction, the seventh storage structure CELL MAT7 is adj acent to the fifth storage structure CELL MAT5 in the third direction, and the eighth storage structure CELL MAT8 is adjacent to the sixth storage structure CELL MAT6 in the third direction.

It should be noted that, as shown in FIG. 5, the memory further includes a fourth memory chip AC-4 located below the third memory chip AC-3. The fourth memory chip AC-4 includes the seventh storage structure CELL MAT7 and the eighth storage structure CELL MAT8. The seventh storage structure CELL MAT7 is located below the fifth storage structure CELL MAT5, and the eighth storage structure CELL MAT8 is located below the sixth storage structure CELL MAT6.

An even-numbered bit line in the fifth storage structure CELL MAT5 is twisted and connected to an even-numbered bit line in the eighth storage structure CELL MAT8. An even-numbered bit line in the sixth storage structure CELL MAT6 is twisted and connected to an even-numbered bit line in the seventh storage structure CELL MAT7. As shown in FIG. 5, the bit line BLB<0> in the fifth storage structure CELL MAT5 is connected to a bit line BL<0> in the eighth storage structure CELL MAT8; the bit line BLB<2> in the fifth storage structure CELL MAT5 is connected to a bit line BL<2> in the eighth storage structure CELL MAT8; the bit line BL<0> in the sixth storage structure CELL MAT6 is connected to a bit line BLB<0> in the seventh storage structure CELL MAT7; and a bit line BL<2> in the sixth storage structure CELL MAT6 is connected to a bit line BLB<2> in the seventh storage structure CELL MAT7.

In addition, as shown in FIG. 5, the odd-numbered bit line BLB<1> and the odd-numbered bit line BLB<3> in the third storage structure CELL MAT3 are connected to bit lines in the first memory chip AC-1 without being twisted, and are twisted and connected to bit lines in a storage structure (not shown in the figure) located on the lower left of the third storage structure CELL MAT3. An odd-numbered bit line in the fifth storage structure CELL MAT5 is twisted and connected to a bit line in a storage structure (not shown in the figure) located on the upper left of the fifth storage structure CELL MAT5, and is connected to an odd-numbered bit line in the seventh storage structure CELL MAT7 below the fifth storage structure CELL MAT5 without being twisted. The same principle applies to the second, the fourth, the sixth, and the eighth storage structures, and details are omitted herein for simplicity.

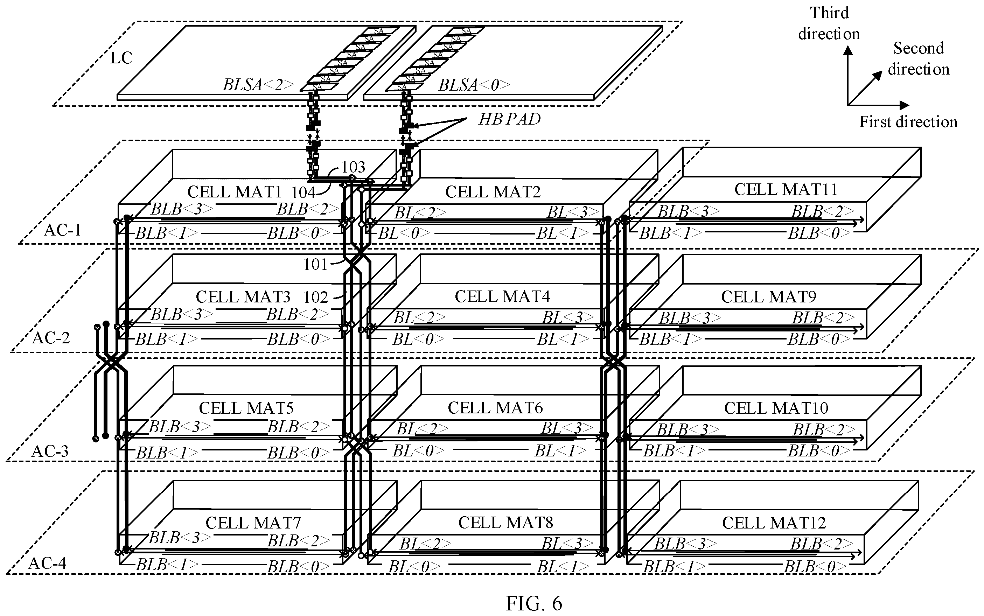

Based on FIG. 5, as shown in FIG. 6, the memory further includes a ninth storage structure CELL MAT9 and a tenth storage structure CELL MAT10. The ninth storage structure CELL MAT9 belongs to the second memory chip AC-2, and the tenth storage structure CELL MAT10 belongs to the third memory chip AC-3. In the first direction, the ninth storage structure CELL MAT9 is located on a side of the fourth storage structure CELL MAT4 away from the third storage structure CELL MAT3, and the tenth storage structure CELL MAT10 is located on a side of the sixth storage structure CELL MAT6 away from the fifth storage structure CELL MAT5.

The m^{th} bit line BL<m> in the fourth storage structure CELL MAT4 is connected to the m^{th} bit line BLB<m> in the tenth storage structure CELL MAT10.

The m^{th} bit line BL<m> in the sixth storage structure CELL MAT is connected to the m^{th} bit line BLB<m> in the ninth storage structure CELL MAT9.

i is one of an odd number or an even number, and m is the other of the odd number or the even number.

In this embodiment, multiple storage structures arranged in the same manner may be included on both sides of the first direction. The same principle applies to the second direction. Moreover, multiple memory chips may be stacked along the third direction in the same manner.

In FIG. 6, even-numbered bit lines BL/BLB are twisted to compensate for coupling noise between the first memory chip AC-1 and the second memory chip AC-2, and compensate for coupling noise between the third memory chip AC-3 and the fourth memory chip AC-4. Odd-numbered bit lines BL/BLB are also twisted between the second memory chip AC-2 and the third memory chip AC-3.

In the example of FIG. 6, i is an even number, and m is an odd number. Taking the fourth storage structure CELL MAT4 as an example, an even-numbered bit line BL<i> is twisted and connected to an even-numbered bit line BLB<i> in the first storage structure CELL MAT1 located on the upper left of the fourth storage structure CELL MAT4, and an odd-numbered bit line BL<m> is twisted and connected to an odd-numbered bit line BLB<m> in the tenth storage structure CELL MAT10 located on the lower right of the fourth storage structure CELL MAT4.

It can be learned that, in this embodiment of the present disclosure, the following is possible: a bit line is twisted and connected to a bit line in one of an upper memory chip and a lower memory chip, and has no twisted connection to a bit line in the other memory chip. Therefore, each bit line is twisted and connected (the top-layer chip and the bottom-layer chip are special cases, and an odd-numbered bit line or an even-numbered bit line possibly has no twisted connection), thereby reducing parasitic capacitance between bit lines, decreasing coupling noise, and ensuring accuracy of data transmitted by the bit lines.

In this embodiment of the present disclosure, the following may also be possible: an odd-numbered bit line and an even-numbered bit line in any storage structure cannot be both twisted and connected to bit lines in the same memory chip. Instead, an odd-numbered bit line is twisted and connected to a bit line in a lower memory chip if an even-numbered bit line is twisted and connected to a bit line in an upper memory chip, for example, as in the third storage structure CELL MAT3 in FIG. 6; and an odd-numbered bit line is twisted and connected to a bit line in an upper memory chip if an even-numbered bit line is twisted and connected to a bit line in a lower memory chip, for example, as in the sixth storage structure CELL MAT6 in FIG. 6. In this way, parasitic capacitance and parasitic resistance caused by excessively long wiring are further avoided.

In some embodiments, as shown in FIG. 6, the memory further includes an eleventh storage structure CELL MAT11 and a twelfth storage structure CELL MAT12. The eleventh storage structure CELL MAT11 belongs to the first memory chip AC-1, and the twelfth storage structure CELL MAT12 belongs to the fourth memory chip AC-4. In the first direction, the eleventh storage structure CELL MAT 11 is located on a side of the second storage structure CLEE MAT2 away from the first storage structure CELL MAT 1, and the twelfth storage structure CELL MAT12 is located on a side of the eighth storage structure CELL MAT8 away from the seventh storage structure CELL MAT7.

The m^{th} bit line BL<m> in the second storage structure CELL MAT2 is connected to the m^{th} bit line BL<m> in the fourth storage structure CELL MAT4.

The m^{th} bit line BL<m> in the sixth storage structure CELL MAT6 is connected to the m^{th} bit line BL<m> in the eighth storage structure CELL MAT8.

The m^{th} bit line BLB<m> in the eleventh storage structure CELL MAT11 is connected to the m^{th} bit line BLB<m> in the ninth storage structure CELL MAT9.

The m^{th} bit line BLB<m> in the tenth storage structure CELL MAT10 is connected to the m^{th} bit line BLB<m> in the twelfth storage structure CELL MAT12.

Based on the foregoing FIG. 2 to FIG. 6, each storage structure may include multiple bit lines. Based on such a stacked structure, e.g., four layers of memory chips, storage density can be increased. In addition, because parasitic capacitance is reduced, a distance between bit lines can be made closer in a storage structure, thereby further increasing the storage density.

In this embodiment of the present disclosure, as shown in FIG. 6, a bit line connection manner between the first storage structure CELL MAT 1, the second storage structure CELL MAT2, the third storage structure CELL MAT3, the fourth storage structure CELL MAT4, the fifth storage structure CELL MAT5, the sixth storage structure CELL MAT6, the seventh storage structure CELL MAT7, and the eighth storage structure CELL MAT8 is denoted as a first twisted manner; and a bit line connection manner between the second storage structure CELL MAT2, the fourth storage structure CELL MAT4, the sixth storage structure CELL MAT6, the eighth storage structure CELL MAT8, the ninth storage structure CELL MAT9, the tenth storage structure CELL MAT10, the eleventh storage structure CELL MAT11, and the twelfth storage structure CELL MAT12 is denoted as a second twisted manner. It can be learned that, in the first direction, twisted manners between adjacent storage structures CELL MAT are alternately the first twisted manner and the second twisted manner. In this way, parasitic capacitance of each bit line is reduced, and system noise is decreased.

In some embodiments, the logic chip LC is located in a first wafer. For memory chips, in a first implementation, the multiple layers of memory chips AC are all located in a second wafer, and the multiple layers of memory chips AC are electrically connected through a through-silicon via or another securing manner; or in a second implementation, the multiple layers of memory chips AC are respectively located in different wafers, and the multiple layers of memory chips are connected in a hybrid bonding manner.

FIG. 5 is taken as an example. The four layers of memory chips may be respectively four array chips, or may all be created on one chip (silicon chip).

It should be noted that, based on different architectures, the memory chips may be connected through a through-silicon via (TSV) or HB, and the logic chip LC may be connected to the most adjacent memory chip AC through HB in this embodiment of the present disclosure. The memory may be a DRAM.

In conclusion, the following problem exists in an existing DRAM architecture: noise is very large, affecting a sense margin, and thus affecting increase in storage density. Especially in a 4F2 structure, as a proportion of parasitic capacitance between bit lines to overall bit-line parasitic capacitance increases, the problem becomes more serious. Therefore, in the embodiments of the present disclosure, a new architecture is designed to cancel noise and provide a high degree of integration (i.e., high storage density) for the DRAM. Specifically, a hybrid bonding technology is utilized in the embodiments of the present disclosure to fabricate a logic chip of a peripheral circuit on one wafer (the first wafer), and fabricate the DRAM (multiple memory chips) on another wafer (the second wafer) or multiple wafers to implement a WoW architecture. During interconnection implementation, system noise can be decreased with effective optimization and a method for twisting a bit line, for example, twisting an even-numbered or odd-numbered bit line/reference bit line, thereby achieving a higher degree (e.g., two-fold, four-fold, or even higher) of integration of the DRAM.

The foregoing descriptions are merely example embodiments of the present disclosure, and are not intended to limit the protection scope of the present disclosure.

It should be noted that in the present disclosure, the terms "include", "comprise", or any other variant thereof are intended to cover non-exclusive inclusion, so that a process, method, article, or apparatus that includes a series of elements includes not only those elements but also other elements that are not expressly listed, or further includes elements inherent to such a process, method, article, or apparatus. An element preceded by "includes a..." does not, without more constraints, preclude the presence of additional identical elements in the process, method, article, or apparatus that includes the element.

The sequence numbers of the foregoing embodiments of the present disclosure are merely for the purpose of description, and do not represent priorities of the embodiments.

The methods disclosed in the several method embodiments provided in the present disclosure may be randomly combined when there is no conflict, to obtain new method embodiments.

The features disclosed in the several product embodiments provided in the present disclosure may be randomly combined when there is no conflict, to obtain new product embodiments.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A memory, comprising a plurality of layers of memory chips (AC) and a logic chip (LC) stacked in a third direction, each of the memory chips (AC) comprising a plurality of storage structures (CELL MAT) arranged in a first direction and a second direction, each of the storage structures (CELL MAT) having a plurality of bit lines (BL) arranged in the second direction, the logic chip (LC) comprising a plurality of sense amplifiers (SA) arranged in the second direction, and every two of the first direction, the second direction, and the third direction intersecting each other;
the i^{th} bit line in a first storage structure (CELL MAT1) being connected to the i^{th} bit line in a fourth storage structure (CELL MAT4), and being connected to one end of a corresponding one of the sense amplifiers (SA); and
the i^{th} bit line in a third storage structure (CELL MAT3) being connected to the i^{th} bit line in a second storage structure (CELL MAT2), and being connected to the other end of the corresponding one of the sense amplifiers (SA); and i being an odd number or an even number;
the first storage structure (CELL MAT1) being adjacent to the third storage structure (CELL MAT3) in the third direction; the fourth storage structure (CELL MAT4) and the third storage structure (CELL MAT3) being located in the same one of the memory chips (AC) and adjacent to each other in the first direction; the second storage structure (CELL MAT2) being adjacent to the fourth storage structure (CELL MAT4) in the third direction; and the second storage structure (CELL MAT2) and the first storage structure (CELL MAT1) being located in the same one of the memory chips (AC) and adjacent to each other in the first direction.

2. The memory according to claim 1, wherein when i is an even number, the (i+1)^{th} bit line in the first storage structure (CELL MAT1) is connected to the (i+1)^{th} bit line in the third storage structure (CELL MAT3), and the (i+1)^{th} bit line in the second storage structure (CELL MAT2) is connected to the (i+1)^{th} bit line in the fourth storage structure (CELL MAT4); and
when i is an odd number, the (i-1)^{th} bit line in the first storage structure (CELL MAT1) is connected to the (i-1)^{th} bit line in the third storage structure (CELL MAT3), and the (i-1)^{th} bit line in the second storage structure (CELL MAT2) is connected to the (i-1)^{th} bit line in the fourth storage structure (CELL MAT4).

3. The memory according to claim 1, wherein the memory further comprises a fifth storage structure (CELL MAT5) and a sixth storage structure (CELL MAT6);
the i^{th} bit line in the third storage structure (CELL MAT3) is further connected to the k^{th} bit line in the fifth storage structure (CELL MAT5); and
the i^{th} bit line in the fourth storage structure (CELL MAT4) is further connected to the k^{th} bit line in the sixth storage structure (CELL MAT6);
the fifth storage structure (CELL MAT5) and the sixth storage structure (CELL MAT6) being located in the same one of the memory chips (ACs) and adj acent to each other in the first direction, the fifth storage structure (CELL MAT5) being adjacent to the third storage structure (CELL MAT3) in the third direction, the sixth storage structure (CELL MAT6) being adjacent to the fourth storage structure (CELL MAT4) in the third direction, and k is an odd number or an even number.

4. The memory according to claim 3, wherein the memory further comprises a seventh storage structure (CELL MAT7) and an eighth storage structure (CELL MAT8);
the k^{th} bit line in the fifth storage structure (CELL MAT5) is further connected to the k^{th} bit line in the eighth storage structure (CELL MAT8); and
the k^{th} bit line in the sixth storage structure (CELL MAT6) is further connected to the k^{th} bit line in the seventh storage structure (CELL MAT7);
the seventh storage structure (CELL MAT7) and the eighth storage structure (CELL MAT8) being located in the same one of the memory chips (ACs) and adjacent to each other in the first direction, the seventh storage structure (CELL MAT7) being adjacent to the fifth storage structure (CELL MAT5) in the third direction, and the eighth storage structure (CELL MAT8) being adjacent to the sixth storage structure (CELL MAT6) in the third direction.

5. The memory according to claim 3, wherein both i and k are even numbers, or both i and k are odd numbers, or i is one of an odd number or an even number, and k is the other of the odd number or the even number.

6. The memory according to claim 4, wherein the memory further comprises a ninth storage structure (CELL MAT9) and a tenth storage structure (CELL MAT10); and in the first direction, the ninth storage structure (CELL MAT9) is located on a side of the fourth storage structure (CELL MAT4) away from the third storage structure (CELL MAT3), and the tenth storage structure (CELL MAT10) is located on a side of the sixth storage structure (CELL MAT6) away from the fifth storage structure (CELL MAT5);
the m^{th} bit line of the fourth storage structure (CELL MAT4) is connected to the m^{th} bit line of the tenth storage structure (CELL MAT 10); and
the m^{th} bit line of the sixth storage structure (CELL MAT6) is connected to the m^{th} bit line of the ninth storage structure (CELL MAT9);
i being one of an odd number or an even number, and m being the other of the odd number or the even number.

7. The memory according to claim 6, wherein the memory further comprises an eleventh storage structure (CELL MAT 11) and a twelfth storage structure (CELL MAT 12); and in the first direction, the eleventh storage structure (CELL MAT11) is located on a side of the second storage structure (CELL MAT2) away from the first storage structure (CELL MAT1), and the twelfth storage structure (CELL MAT 12) is located on a side of the eighth storage structure (CELL MAT8) away from the seventh storage structure (CELL MAT7);
the m^{th} bit line of the second storage structure (CELL MAT2) is connected to the m^{th} bit line of the fourth storage structure (CELL MAT4); and
the m^{th} bit line of the sixth storage structure (CELL MAT6) is connected to the m^{th} bit line of the eighth storage structure (CELL MAT8).

8. The memory according to claim 7, wherein a bit line connection manner between the first storage structure (CELL MAT1), the second storage structure (CELL MAT2), the third storage structure (CELL MAT3), the fourth storage structure (CELL MAT4), the fifth storage structure (CELL MAT5), the sixth storage structure (CELL MAT6), the seventh storage structure (CELL MAT7), and the eighth storage structure (CELL MAT8) is denoted as a first twisted manner; and a bit line connection manner between the second storage structure (CELL MAT2), the fourth storage structure (CELL MAT4), the sixth storage structure (CELL MAT6), the eighth storage structure (CELL MAT8), the ninth storage structure (CELL MAT9), the tenth storage structure (CELL MAT10), the eleventh storage structure (CELL MAT11), and the twelfth storage structure (CELL MAT12) is denoted as a second twisted manner; and
in the first direction, twisted manners between adjacent ones of the storage structures (CELL MAT) are alternately the first twisted manner and the second twisted manner.

9. The memory according to claim 1, wherein the memory is a dynamic random access memory, and the logic chip (LC) is located in a first wafer; and
the plurality of layers of memory chips (AC) are all located in a second wafer, and the plurality of layers of memory chips (AC) are connected through a through-silicon via; or the plurality of layers of memory chips (AC) are respectively located in different wafers, and the plurality of layers of memory chips (AC) are connected in a hybrid bonding manner.
